# EUROPEAN PATENT APPLICATION

(11) **EP 4 851 718 A1**
(43) Date of publication of application: **09.12.2026**
(21) Application number: 26181270.5
(22) Date of filing: 27.05.2026
(51) Int. Cl.: G03F 9/00, G06T 7/73

(54) **DETERMINATION METHOD, PROGRAM, DETECTION APPARATUS, LITHOGRAPHY APPARATUS, AND ARTICLE MANUFACTURING METHOD**

(30) Priority: 03.06.2025 JP 2025092908
(71) Applicant: CANON KABUSHIKI KAISHA, Ohta-ku Tokyo 146-8501 (JP)
(72) Inventor: SAKAMOTO, Yoshiki, Tokyo (JP); MASUDA, Mitsuhiro, Tokyo (JP)
(74) Representative: WESER & Kollegen Patentanwälte PartmbB

(57) **Abstract**

A determination method for determining a template used for template matching is provided. The method includes searching, from an image, for a first pattern similar to a temporary template, and when a combination of the first pattern and a second pattern having a predetermined positional relationship with the first pattern is unique in the image, determining the temporary template as a template used for the template matching.

## Description

### TECHNICAL FIELD

The present disclosure relates to a determination method, a program, a detection apparatus, a lithography apparatus, and an article manufacturing method.

### BACKGROUND

In a lithography apparatus that transfers a pattern of an original onto a substrate to form a pattern on the substrate, alignment between the original and the substrate is necessary. The alignment generally includes measurement of the position of a mark formed on the substrate, and the measurement can be performed by pattern matching using a template (template matching).

When the shape of the mark varies due to process factors or the like, the measurement accuracy may decrease with an unchanged template. Japanese Patent Laid-Open No. 2013-102234 discloses a method of performing pattern matching processing again using another template when a mark does not match the template.

### SUMMARY

On the substrate, various patterns exist in addition to the registered pattern serving as the template, and some of them may be patterns similar to the registered pattern, so that there is a possibility that a pattern other than the mark that should originally be detected may be erroneously detected.

The present disclosure provides a technique advantageous for reducing erroneous detection of a mark by template matching.

The present disclosure in its first aspect provides a determination method as specified in claim 1. Optional features are specified in claim 2 to 9.

The present disclosure in its second aspect provides a program as specified in claim 10.

The present disclosure in its third aspect provides a detection apparatus as specified in claim 11.

The present disclosure in its fourth aspect provides a lithography apparatus as specified in claim 12.

The present disclosure in its fifth aspect provides an article manufacturing method as specified in claim 13.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
FIG. 1 is a diagram showing the configuration of an exposure apparatus.
FIG. 2 is a diagram showing the configuration of a substrate alignment optical system as a detection apparatus.
FIG. 3 is a diagram schematically showing an arrangement of marks provided on a substrate.
FIG. 4 is a flowchart of template registration processing.
FIG. 5 is a flowchart of template registration processing.
FIG. 6 is a flowchart of template registration processing.
FIG. 7 is a flowchart of template registration processing.
FIG. 8 is a diagram showing the configuration of a substrate processing system.
FIG. 9 is a flowchart of template registration processing in a substrate processing system.
FIG. 10 is a flowchart of a determination method for determining a template used for template matching.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

The present disclosure relates to a detection apparatus that detects the position of a substrate. The detection apparatus can typically be applied to alignment between an original and a substrate in a lithography apparatus such as an exposure apparatus or an imprint apparatus, but can also be applied to other apparatuses such as a processing apparatus, an inspection apparatus, and a microscope. The exposure apparatus is an apparatus that projects a pattern of an original onto a substrate through a projection optical system to form a pattern on the substrate. The imprint apparatus is an apparatus that forms a pattern on a substrate by bringing a pattern surface of an original into contact with an imprint material on the substrate. Hereinafter, an example in which the detection apparatus is applied to an exposure apparatus, which is a lithography apparatus, will be described. That is, the lithography apparatus in the embodiment detects a mark formed on a substrate by the detection apparatus, aligns a substrate stage based on the result of the detection, and transfers a pattern of an original onto the substrate held by the aligned substrate stage.

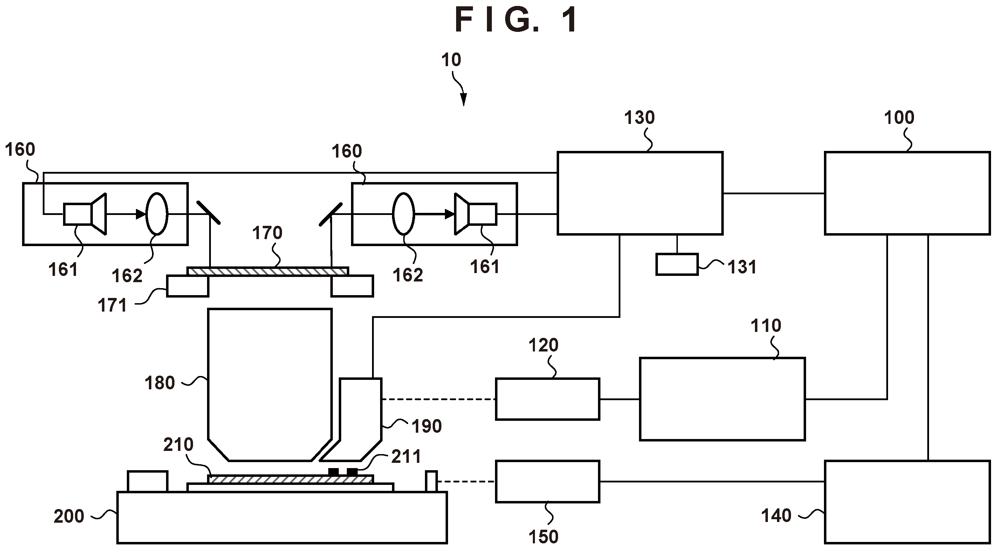

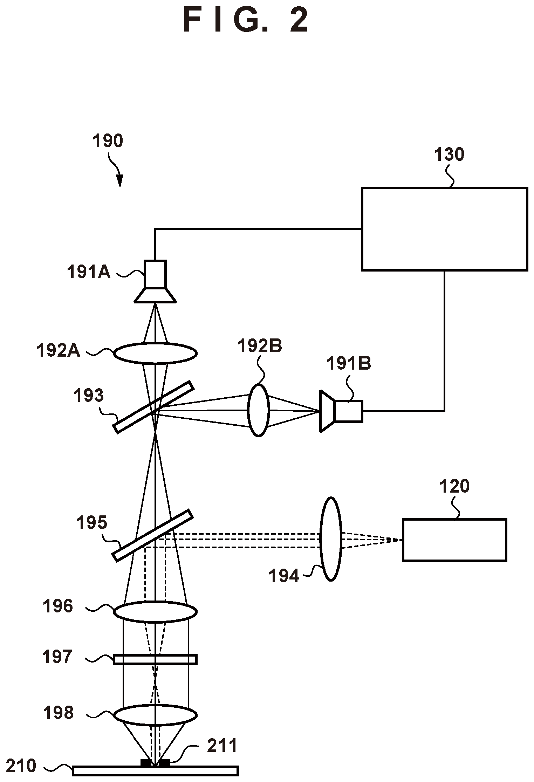

FIG. 1 is a diagram showing the configuration of an exposure apparatus 10. FIG. 2 is a diagram showing the configuration of a substrate alignment optical system 190 as a detection apparatus included in the exposure apparatus 10. The exposure apparatus 10 is a lithography apparatus used for manufacturing devices such as semiconductor elements, liquid crystal display elements, and thin-film magnetic heads as articles, and performs pattern formation on a substrate. In one example, the exposure apparatus 10 exposes a substrate by a step-and-scan method or a step-and-repeat method.

As shown in FIG. 1, the exposure apparatus 10 may include a main controller 100, a light source controller 110, a light source 120, an image processor 130, a stage controller 140, and an interferometer 150. The exposure apparatus 10 may also include an original alignment optical system 160, an original stage 171, a projection optical system 180, the substrate alignment optical system 190, and a substrate stage 200.

The original stage 171 holds and moves an original 170 illuminated by an illumination optical system (not shown). A pattern to be transferred to the substrate 210 is drawn on the original 170.

The projection optical system 180 projects the pattern of the original 170 onto the substrate 210. The substrate stage 200 can hold and move the substrate 210.

The original alignment optical system 160 is used for alignment of the original 170. For example, the original alignment optical system 160 includes an image sensor 161 composed of a storage-type photoelectric conversion element, and an optical system 162 that guides light from a mark provided on the original 170 to the image sensor 161.

The substrate alignment optical system 190 is used for alignment of the substrate 210. In the present embodiment, the substrate alignment optical system 190 is an off-axis optical system that detects a mark 211 provided on the substrate 210.

The main controller 100 includes a CPU, a memory, and the like, and controls each part of the exposure apparatus 10 to perform exposure processing for exposing the substrate 210 and processing related thereto. The main controller 100 also controls the position of the substrate stage 200 based on the position of the mark formed on the original 170 and the position of the mark 211 formed on the substrate 210. In one example, the main controller 100 performs alignment between the original 170 and the substrate 210, for example, global alignment.

The light source 120 includes a halogen lamp or the like, and illuminates the mark 211 formed on the substrate 210. The light source controller 110 controls the illumination intensity of light from the light source 120, that is, light for illuminating the mark 211.

The image processor 130 processes image signals (detection signals) from the image sensor 161 in the original alignment optical system 160 and the image sensors 191A and 191B in the substrate alignment optical system 190 to obtain the position of a mark. In the present embodiment, the image processor 130 can function as a processing unit that executes a determination method for determining a template used for template matching. The image processor 130 can also function as a processing unit that performs processing for detecting a mark by template matching using the template determined in accordance with the determination method. A storage unit 131 that stores various data such as the determination method and information relating to the template is connected to the image processor 130.

The interferometer 150 measures the position of the substrate stage 200 by irradiating a mirror 212 provided on the substrate stage 200 with light and detecting light reflected by the mirror 212. The stage controller 140 moves the substrate stage 200 to an arbitrary position (drives and controls the substrate stage 200) based on the position of the substrate stage 200 measured by the interferometer 150.

In the exposure apparatus 10, light (exposure light) from an illumination optical system not shown passes through the original 170 held by the original stage 171 and enters the projection optical system 180. Then, because the original 170 and the substrate 210 are arranged in an optically conjugate positional relationship with each other, the pattern of the original 170 is imaged and transferred onto the substrate 210 held by the substrate stage 200 through the projection optical system 180.

The substrate alignment optical system 190 functions as a detection apparatus that detects the mark 211 formed on the substrate 210 and generates a detection signal (an image signal in the present embodiment). The substrate alignment optical system 190 may include an imaging unit that images the substrate 210 held by the substrate stage 200. As shown in FIG. 2, the substrate alignment optical system 190 includes image sensors 191A and 191B, imaging optical systems 192A and 192B, and a half mirror 193. The substrate alignment optical system 190 also includes an illumination optical system 194, a polarization beam splitter 195, a relay lens 196, a λ/4 plate 197, and an objective lens 198.

In the exposure apparatus 10, light from the light source 120 is guided to the substrate alignment optical system 190 through an optical fiber (not shown) or the like. Then, the light guided to the substrate alignment optical system 190 enters the polarization beam splitter 195 through the illumination optical system 194, as shown in FIG. 2. Then, the light reflected by the polarization beam splitter 195 passes through the relay lens 196, the λ/4 plate 197, and the objective lens 198, and illuminates the mark 211 formed on the substrate 210.

Light reflected by the mark 211 passes through the objective lens 198, the λ/4 plate 197, the relay lens 196, and the polarization beam splitter 195, and enters the half mirror 193. Then, after the light entering the half mirror 193 is divided by the half mirror 193 into two beams at an appropriate intensity ratio, the beams are respectively guided to the imaging optical systems 192A and 192B having mutually different imaging magnifications. The imaging optical systems 192A and 192B each form an image of the mark 211 on the imaging surfaces of the image sensors 191A and 191B. The image sensors 191A and 191B each include an imaging surface that images a region including the mark 211, and generate an image signal corresponding to the region imaged on the imaging surface. Then, the image signals generated by the image sensors 191A and 191B are read out by the image processor 130.

In the present embodiment, the image processor 130 performs template matching (pattern matching) processing as image processing on the read image signals. Thereby, the image processor 130 obtains the position of the mark 211 on the imaging surfaces of the image sensors 191A and 191B.

Template matching is generally broadly classified into the following two types. One is a method in which an image (grayscale image) is binarized and matched with a template prepared in advance, and the position having the highest correlation is taken as the position of the mark 211. The other is a method of obtaining the position of the mark 211 by performing a correlation operation with a template including grayscale information while maintaining the grayscale image as it is. The image processing by the image processor 130 is not limited to template matching, and may be other processing such as edge detection processing as long as the processing can obtain position information of the mark 211.

As alignment methods, there are a moving measurement method and an image processing method. In the moving measurement method, light (laser) is irradiated onto the mark 211 provided on the substrate 210 while moving the substrate stage 200. Then, the position of the mark 211 is obtained by measuring in parallel the change in intensity of the light reflected from the mark 211 and the position of the substrate stage 200. In the image processing method, white light is irradiated onto the mark 211 provided on the substrate 210 while the substrate stage 200 is stationary. Then, the position of the mark 211 is obtained by detecting light reflected from the mark 211 with a storage-type photoelectric conversion element and performing image processing.

As alignment optical systems used for such alignment methods, there are a TTL (through-the-lens) optical system, a TTR (through-the-reticle) optical system, and an off-axis optical system. The TTL optical system detects a mark provided on the substrate through the projection optical system. The TTR optical system simultaneously detects a mark provided on the reticle and a mark provided on the substrate through the projection optical system. The off-axis optical system is a dedicated optical system having an optical axis at a position separated by a predetermined distance from the optical axis of the projection optical system without going through the projection optical system, and detects a mark provided on the substrate by irradiating white light from a dedicated light source. As described above, the substrate alignment optical system 190 according to the present embodiment is an off-axis optical system.

In the exposure apparatus 10, two types of alignment, prealignment (coarse alignment) and fine alignment (precision alignment), are performed using the obtained position information of the mark 211. Prealignment means detecting the amount of positional deviation of the substrate 210 fed from a substrate conveyance system not shown to the substrate stage 200 and roughly aligning (positioning) the substrate 210 so that fine alignment can be started. Fine alignment means precisely aligning (positioning) the substrate 210 by measuring the position of the substrate 210 held by the substrate stage 200 with high accuracy so that the alignment error of the substrate 210 falls within an allowable range.

In prealignment, as described above, the amount of positional deviation of the substrate 210 fed from the substrate conveyance system not shown to the substrate stage 200 must be detected. Therefore, the substrate alignment optical system 190 that detects the mark 211 has a wide detection range (field of view) relative to the size of the mark 211. To obtain the position (XY coordinates) of the mark 211 from such a wide detection range, the above-described pattern matching processing (template matching processing) is often used. In pattern matching processing, the degree of correlation with the template is obtained, and the position is detected when the degree of correlation satisfies an allowable condition. The degree of correlation is an index representing the correlation (similarity) between a part of a target image and the template. For example, the degree of correlation may be obtained using similarity such as Normalized Cross-Correlation (NCC), or the degree of correlation may be obtained using dissimilarity such as Sum of Squared Differences (SSD) and Sum of Absolute Differences (SAD).

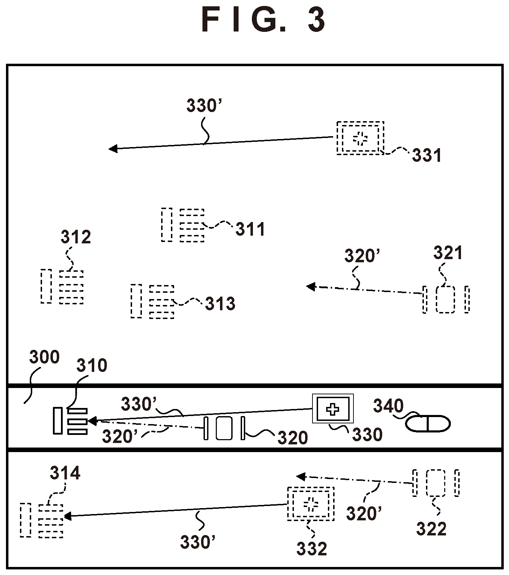

FIG. 3 is a diagram schematically showing the arrangement of marks provided on a substrate. Marks 310, 320, 330, and 340 are arranged within a scribe line 300. Similar patterns 311 to 314 exist around the mark 310, and similar patterns 321 and 322 exist around the mark 320. Similar patterns 331 and 332 exist around the mark 330. On the other hand, no similar pattern exists around the mark 340. A relative position 320' is the relative position between the mark 310 and the mark 320, and a relative position 330' is the relative position between the mark 310 and the mark 330.

Whether a pattern is a similar pattern of a mark may be determined, for example, by comparing the degree of correlation obtained when template matching is performed on surrounding images at predetermined intervals with a threshold value (reference value). For example, a pattern having a degree of correlation with the temporary template higher than the threshold value can be extracted from an image as a similar pattern (a first pattern described later). Alternatively, whether a pattern is a similar pattern of a mark may be determined by comparing a threshold value with a difference between the degree of correlation of the image used for template creation and the degree of correlation at the time of pattern matching processing.

It is possible to use a specific mark, for example, the mark 310, as a mark for prealignment measurement (prealignment mark), and also to use the mark as a mark for fine alignment measurement (fine alignment mark). However, in that case, depending on the amount of positional deviation of the substrate 210 on the substrate stage 200, there is a possibility that the similar patterns 311 to 314 of the prealignment mark may be erroneously detected.

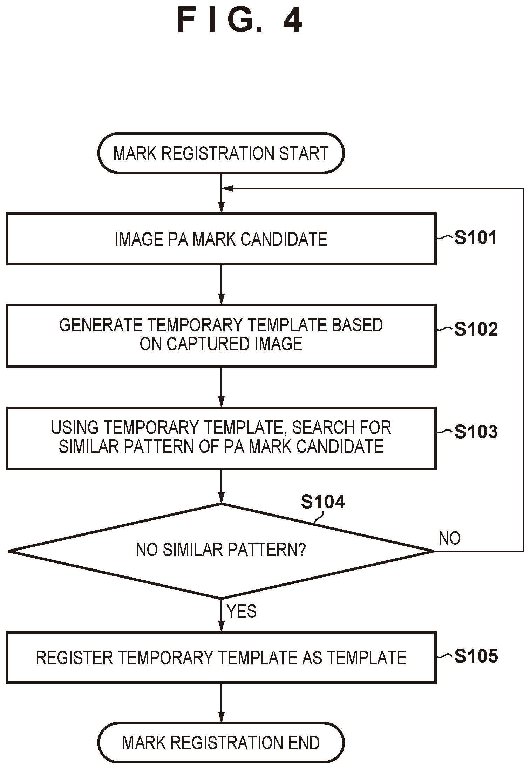

FIG. 4 is a flowchart of template registration processing for registering a template after confirming that there is no similar pattern around a prealignment mark (also referred to as a PA mark). In step S101, the substrate alignment optical system 190 images a candidate for a prealignment mark (PA mark candidate).

In step S102, the image processor 130 generates a temporary template based on an image of the PA mark candidate obtained by imaging. The PA mark candidate can be determined, for example, by searching along the scribe line. The image processor 130 determines feature points constituting a temporary template, for example, based on a total number of feature points predetermined in advance and an interval between the feature points. In one example, the image processor 130 selects, as the temporary template, feature points spatially uniformly arranged from among the extracted candidate points. The selected feature points of the temporary template constituting the temporary template are stored in the storage unit 131 and can be used for template matching. The method for extracting candidate points of feature points and the method for determining feature points constituting the template are not limited to the above-described methods.

In step S103, the image processor 130 performs template matching using the temporary template. Specifically, the substrate alignment optical system 190 images a surrounding region of the PA mark candidate. Thereafter, the image processor 130 performs template matching on the image using the temporary template generated in step S102, and searches for a similar pattern that matches the temporary template.

When a similar pattern of the PA mark candidate exists (NO in step S104), the processing returns to step S101 and is restarted from imaging of the next candidate for the mark for prealignment measurement. This is because such a similar pattern can cause erroneous detection. When no such similar pattern exists (YES in step S104), the processing proceeds to step S105, and the image processor 130 determines the temporary template as the template and registers the template. In one example, registering the template includes storing coordinates of feature points constituting the template in the storage unit 131.

As described above, registration of mark information for prealignment measurement (that is, the template) is performed. Registration of a mark for fine alignment measurement (fine alignment mark) can also be performed in the same manner as described above. Thereby, the possibility of erroneous detection can be reduced. According to the flow of FIG. 4, a template of a mark having no similar pattern in the surroundings (the mark 340 in the example of FIG. 3) can be registered. Thus, by selecting a mark for prealignment measurement having no similar pattern in the surroundings, the possibility of erroneous detection can be reduced.

Next, an example in which there is no mark having no similar pattern in the surroundings (for example, a mark such as the mark 340) will be described. In such a case, for example, different marks are used, such as the mark 330 as the prealignment mark and the mark 310 as the fine alignment mark. At this time, the relative position 330' between the mark 330, which is the prealignment mark, and the mark 310, which is the fine alignment mark (also referred to as an FA mark), is stored. Thereby, the possibility of product defects due to erroneous detection of similar patterns can be reduced.

For example, assume that, in prealignment, the similar pattern 331 is erroneously detected with respect to the mark 330, which is the prealignment mark. In this case, template matching is performed at the relative position 330' from the similar pattern 331. In the example of FIG. 3, no mark exists in the vicinity of the relative position 330' from the similar pattern 331. Therefore, the possibility of detecting an erroneous amount of positional deviation in fine alignment is reduced. On the other hand, consider a case in which, in prealignment, the similar pattern 332 is erroneously detected with respect to the mark 330, which is the prealignment mark. In this case, at the relative position 330' from the similar pattern 332, there exists a similar pattern 314 similar to the mark 310, which is the fine alignment mark. Therefore, there is a possibility of erroneous detection in both prealignment and fine alignment. In the present embodiment, mark registration processing useful for suppressing such erroneous detection of the prealignment mark and erroneous detection of the fine alignment mark is performed.

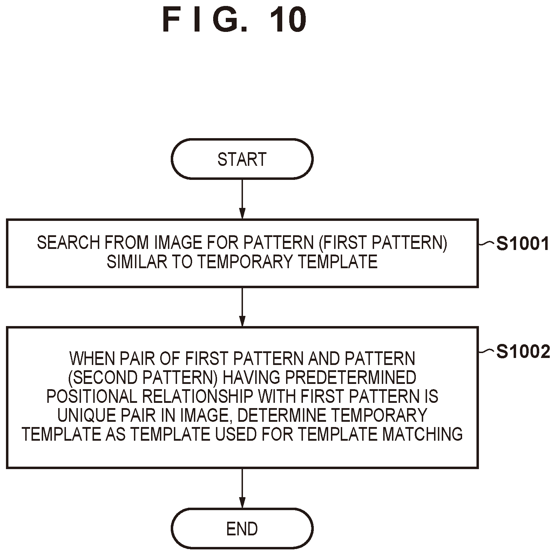

FIG. 10 shows a flowchart of a determination method, performed in the mark registration processing in the present embodiment, for determining a template used for template matching. In step S1001, the image processor 130 searches, from the image, for a pattern (first pattern) similar to a temporary template (corresponding to the prealignment mark). In step S1002, when a pair of the first pattern and a second pattern (corresponding to the fine alignment mark) having a predetermined positional relationship with the first pattern is a unique pair in the image, the image processor 130 determines the temporary template as a template used for template matching. That is, when the combination of the first pattern and the second pattern is unique, the temporary template is used for template matching. When the pair is not a unique pair in the image (when the combination of the first pattern and the second pattern is not unique), the temporary template is excluded from candidates for a template used for template matching.

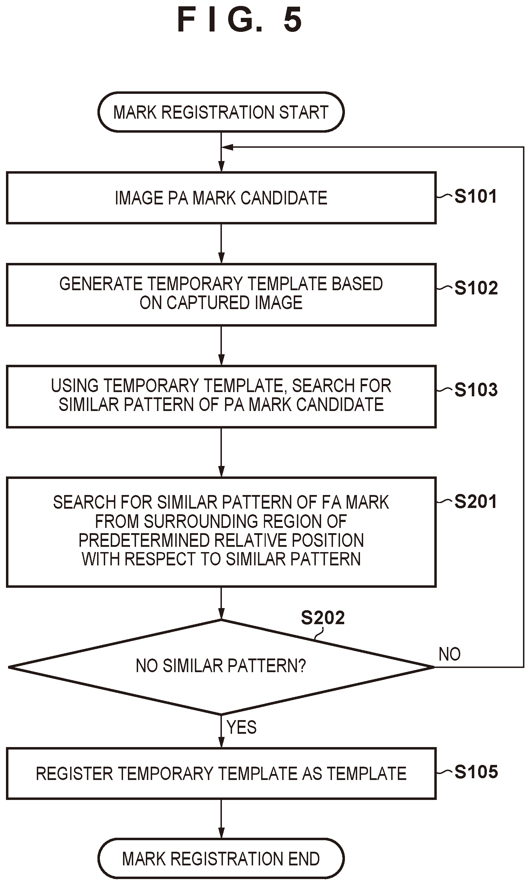

FIG. 5 is a flowchart of mark registration processing in which such a determination method is introduced to improve erroneous-detection suppression performance. The same processing steps as those in the flowchart of FIG. 4 are denoted by the same reference numerals, and descriptions thereof are omitted.

After template matching using the temporary template is performed in step S103 to search for a similar pattern of the prealignment mark candidate, step S201 is executed (step S103 in FIGS. 4 and 5 corresponds to step S1001 in FIG. 10). In step S201, for each of the similar patterns obtained in the search in step S103, the image processor 130 searches, from a surrounding region at a predetermined relative position with respect to the similar pattern, for a similar pattern of the fine alignment mark.

When a similar pattern of the fine alignment mark exists (NO in step S202), the processing returns to step S101 and is restarted from imaging of the next prealignment mark candidate. When no similar pattern of the fine alignment mark exists (YES in step S202), the processing proceeds to step S105, and the image processor 130 determines the temporary template as the template and registers information of the template.

Referring again to FIG. 3, for example, consider a case in which the mark 330 on the scribe line 300 is taken as the prealignment mark candidate. Here, the mark 310 for fine alignment measurement is in a relationship of a predetermined relative position 330' with respect to the mark 330 for prealignment measurement. In the image, similar patterns 331 and 332 similar to the mark 330 for prealignment measurement exist. No mark exists in the vicinity of the relative position 330' from the similar pattern 331. However, at the relative position 330' from the similar pattern 332, there exists a similar pattern 314 similar to the mark 310 for fine alignment measurement. When, as in this case, a pair of similar marks having the same relative positional relationship as the pair of the mark 330 (mark candidate) and the mark 310 is found, the mark 330, which is the mark candidate, is excluded from candidates for the template in step S105.

Next, consider a case in which the mark 320 on the scribe line 300 is taken as a candidate for the mark for prealignment measurement. Here, the mark 310 for fine alignment measurement is in a relationship of a predetermined relative position 320' with respect to the mark 320 for prealignment measurement. In the image, similar patterns 321 and 322 similar to the mark 320 for prealignment measurement exist. However, no mark exists in the vicinity of the relative position 320' from the similar pattern 321 or in the vicinity of the relative position 320' from the similar pattern 322. That is, no pair of similar marks having the same relative positional relationship as the pair of the mark 320 and the mark 310 exists in the image. When, as in this case, no pair of similar marks having the same relative positional relationship as the pair of the mark 320 (mark candidate) and the mark 310 is found, the mark 320, which is the mark candidate, is made subject to registration as the template in step S105.

Thus, in the above mark registration processing, when a first pattern similar to the temporary template is found, a second pattern that can correspond to the fine alignment mark is searched for from a partial region of the image based on a predetermined positional relationship (step S201). When the second pattern is not found from the image (YES in step S202), the temporary template is determined as the template.

According to the above mark registration processing, erroneous detection of a mark by template matching can be reduced.

Before template registration, a plurality of registration candidates may be displayed and selected.

### <Second Embodiment>

In the second embodiment, a temporary template of a mark candidate for prealignment measurement is evaluated on a plurality of substrates. When a pair of a first pattern (pattern of a PA mark) and a second pattern (pattern of an FA mark) is a unique pair in the images over the plurality of substrates, the temporary template is determined as a template used for template matching.

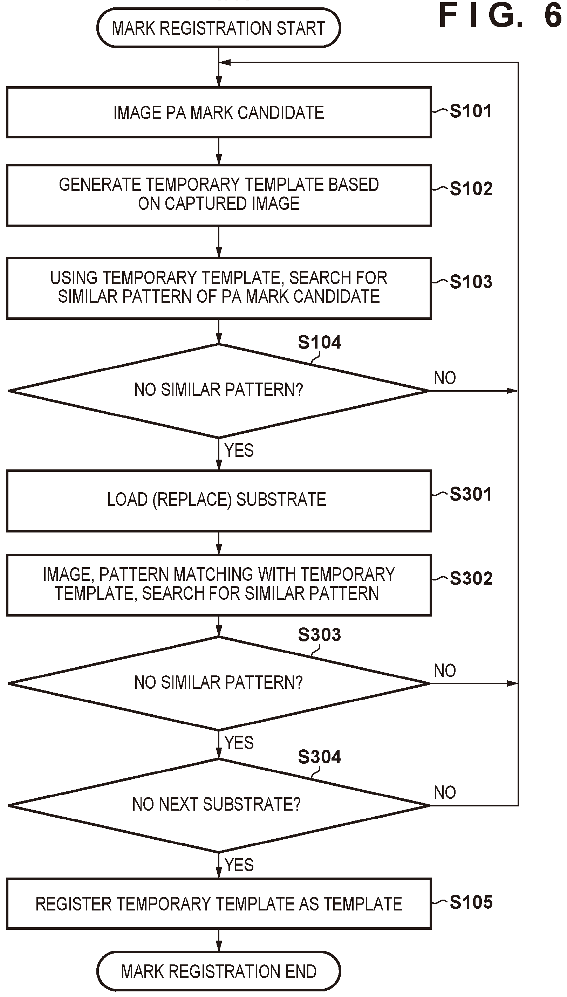

FIG. 6 is a flowchart of template registration processing for registering a template after confirming, for a plurality of substrates, that there is no similar pattern around a mark for prealignment measurement. The same processing steps as those in the flowchart of FIG. 4 are denoted by the same reference numerals, and descriptions thereof are omitted.

In steps S101 to S104, the image processor 130 generates a temporary template of a mark candidate for prealignment measurement having no similar pattern in the surroundings. Thereafter, in step S301, a substrate for template evaluation is loaded. In step S302, the surroundings of the prealignment mark candidate are imaged, template matching using the temporary template is performed, and a surrounding similar pattern is searched for. When a similar pattern of the mark candidate exists (NO in step S303), the processing returns to step S101 and is restarted from imaging of the next mark candidate for prealignment measurement. When no similar pattern exists (YES in step S303), the processing proceeds to step S304. In step S304, it is determined whether there is still a substrate to be processed next. When there is still a substrate to be processed next (NO in step S304), the processing returns to step S301, and the next substrate is loaded (replaced). When there is no substrate to be processed next (YES in step S304), the processing proceeds to step S105, and the image processor 130 determines the temporary template as the template and registers the template.

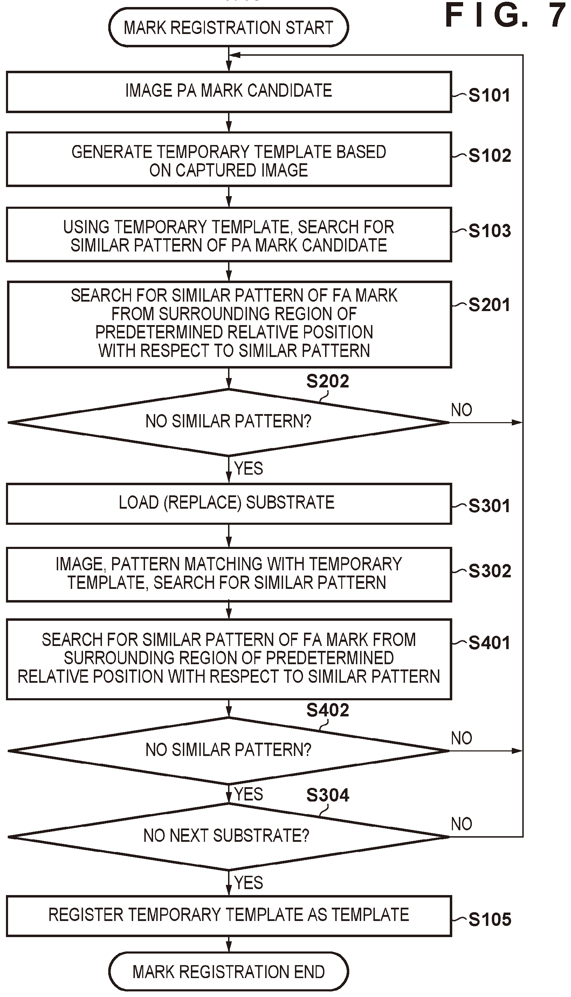

FIG. 7 is a flowchart of mark registration processing in which erroneous-detection suppression performance is improved over the flow of FIG. 6. The same processing steps as those in the flowcharts of FIGS. 5 and 6 are denoted by the same reference numerals, and descriptions thereof are omitted.

In FIG. 7, after step S302, step S401 is executed. In step S401, for each of the similar patterns obtained in the search in step S103, the image processor 130 searches, from a surrounding region at a predetermined relative position with respect to the similar pattern, for a similar pattern of a mark for fine alignment measurement. This is a step similar to step S201 of FIG. 5. When a similar pattern of the mark for fine alignment measurement exists (NO in step S402), the processing returns to step S101 and is restarted from imaging of the next mark candidate for prealignment measurement. When no similar pattern of the mark for fine alignment measurement exists (YES in step S402), the processing proceeds to step S304.

### <Third Embodiment>

In the third embodiment, a temporary template of a mark candidate for prealignment measurement is evaluated by a plurality of apparatuses that process substrates. When a pair of a first pattern (pattern of the PA mark) and a second pattern (pattern of the FA mark) is a unique pair over a plurality of apparatuses, the temporary template is determined as a template used for template matching.

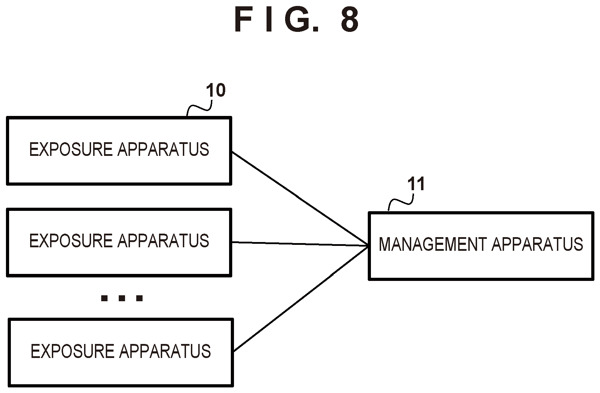

FIG. 8 is a block diagram showing the configuration of a substrate processing system in the third embodiment. The substrate processing system may include, for example, a plurality of exposure apparatuses 10. Each of the plurality of exposure apparatuses 10 is connected to a management apparatus 11 that manages the exposure apparatus. The management apparatus 11 may have an image processor 130 and a storage unit 131 as described in the above embodiments. An inspection apparatus (not shown) for inspecting substrates may be further connected to the management apparatus 11.

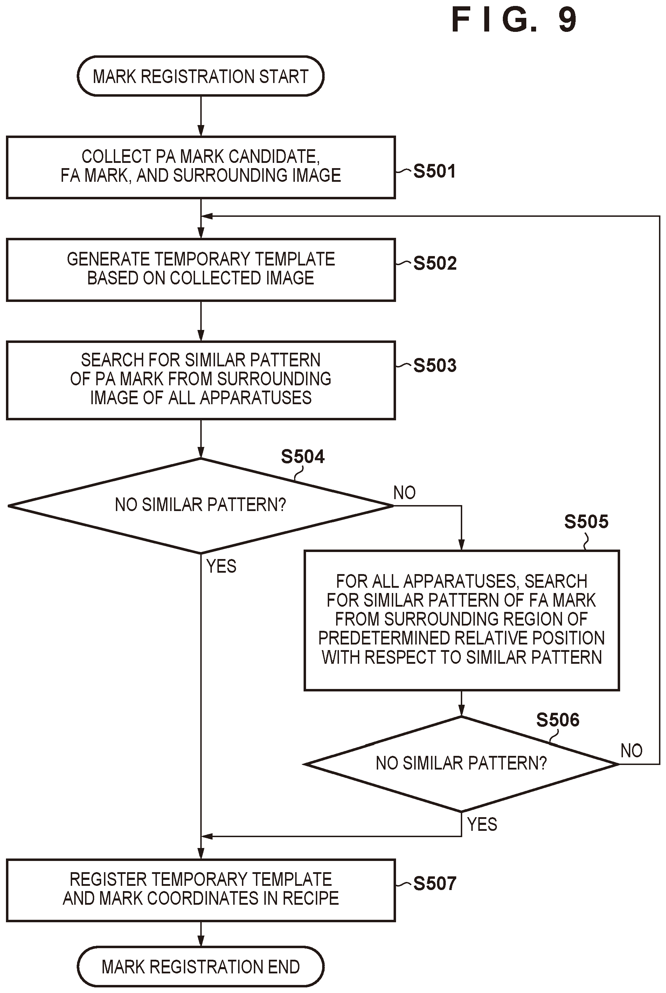

FIG. 9 is a flowchart of template registration processing in the substrate processing system. In step S501, the management apparatus 11 collects, from the exposure apparatus 10, mark candidates for prealignment measurement, marks for fine alignment measurement, and surrounding images of those marks. In step S501, the management apparatus 11 collects mark candidates for prealignment measurement, marks for fine alignment measurement, and surrounding images of those marks, for all regions in the substrate.

In step S502, the management apparatus 11 (the image processor 130 thereof) generates a temporary template based on the collected images of mark candidates for prealignment measurement. In step S503, the management apparatus 11 performs pattern matching with the temporary template on surrounding images of mark candidates for prealignment measurement from all apparatuses, and searches for a similar pattern. When a similar pattern of a mark candidate for prealignment measurement exists (NO in step S504), the processing proceeds to step S505. When no similar pattern of a mark candidate for prealignment measurement exists (YES in step S504), the processing proceeds to step S507. In step S507, the management apparatus 11 determines the temporary template as the template and registers the template. In step S505, for similar patterns in the surroundings in all apparatuses, the management apparatus 11 searches, from a surrounding region at a predetermined relative position with respect to the similar pattern, for a similar pattern of the mark for fine alignment measurement.

When a similar pattern of the mark for fine alignment measurement exists (NO in step S506), the processing returns to step S501 and is restarted from imaging of the next mark candidate for prealignment measurement. When no similar pattern of the mark for fine alignment measurement exists (YES in step S506), the processing proceeds to step S507, and the management apparatus 11 determines the temporary template as the template and registers the template.

### <Embodiments of Article Manufacturing Method>

The article manufacturing method in the present disclosure is suitable, for example, for manufacturing an article such as a microdevice such as a semiconductor device or an element having a fine structure. The article manufacturing method of the present embodiment includes transferring a pattern of an original onto a substrate using the above lithography apparatus (such as an exposure apparatus, an imprint apparatus, or a drawing apparatus), and processing the substrate onto which the pattern has been transferred in that process. Further, the manufacturing method includes other well-known processes (oxidation, film formation, vapor deposition, doping, planarization, etching, resist stripping, dicing, bonding, packaging, and the like). The article manufacturing method of the present embodiment is advantageous, as compared with a conventional method, in at least one of performance, quality, productivity, and production cost of the article.

According to the various embodiments described above, it is possible to provide a technique advantageous for reducing erroneous detection of a mark by template matching.

### <Other Embodiments>

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{TM}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. A determination method for determining a template used for template matching, the method **characterized by** comprising:
searching (S1001), from an image, for a first pattern similar to a temporary template; and
when a combination of the first pattern and a second pattern having a predetermined positional relationship with the first pattern is unique in the image, determining (S1002) the temporary template as a template used for the template matching.

2. The determination method according to claim 1, **characterized in that**, when the combination is not unique in the image, the temporary template is excluded from candidates for a template used for the template matching.

3. The determination method according to claim 1, **characterized in that**, when the first pattern is found, searching for the second pattern from a partial region of the image based on the predetermined positional relationship,
and, when the second pattern is not found from the image, determining the temporary template as the template.

4. The determination method according to claim 1, **characterized in that** the first pattern is a pattern serving as a mark candidate for prealignment measurement of a substrate,
and the second pattern is a pattern serving as a mark candidate for fine alignment measurement of the substrate.

5. The determination method according to claim 4, **characterized in that** the image is an image obtained by imaging the substrate,
and the temporary template is generated based on the image.

6. The determination method according to claim 5, **characterized in that** the temporary template is generated based on a region representing a scribe line in the image.

7. The determination method according to claim 1, **characterized in that**, from the image, a pattern having a degree of correlation with the temporary template higher than a threshold value is extracted as the first pattern.

8. The determination method according to claim 1, **characterized in that**, when the combination is unique over a plurality of substrates, the temporary template is determined as a template used for the template matching.

9. The determination method according to claim 1, **characterized in that**, when the combination is unique over a plurality of apparatuses that process substrates, the temporary template is determined as a template used for the template matching.

10. A program that causes a computer to execute a determination method for determining a template used for template matching, **characterized in that** the program causes the computer to:
search, from an image, for a first pattern similar to a temporary template; and
when a combination of the first pattern and a second pattern having a predetermined positional relationship with the first pattern is unique in the image, determine the temporary template as a template used for the template matching.

11. A detection apparatus (190) for detecting a mark formed on a substrate, **characterized by** comprising:
a stage (200) that holds and moves the substrate;
an imaging unit (190) that images the substrate held by the stage;
and a processing unit that performs processing for detecting the mark by template matching using a template determined according to the determination method according to claim 1 on the image obtained by the imaging.

12. A lithography apparatus **characterized by** comprising the detection apparatus according to claim 11,
the lithography apparatus detecting a mark formed on a substrate by the detection apparatus, aligning the stage based on a result of the detection, and transferring a pattern of an original onto the substrate held by the aligned stage.

13. An article manufacturing method **characterized by** comprising forming a pattern on a substrate using the lithography apparatus according to claim 12,
processing the substrate on which the pattern has been formed,
and manufacturing an article from the substrate that has been processed.
